# FASCICULE DE BREVET EUROPEEN

(11) **EP 3 159 704 B1**
(45) Date de publication et mention de la délivrance du brevet: **09.06.2021**
(21) Numéro de dépôt: 16195121.5
(22) Date de dépôt: 21.10.2016
(51) Int. Cl.: G01R 1/20, G01R 35/00

(54) **CHAÎNE DE MESURE POUR UN CIRCUIT ÉLECTRONIQUE DE SIGNALISATION**
MESSKETTE FÜR EINE ELEKTRONISCHE SIGNALSCHALTUNG
MEASURING CHAIN FOR A SIGNALLING ELECTRONIC CIRCUIT

(30) Priorité: 23.10.2015 FR 1560166
(43) Date de publication de la demande: 26.04.2017
(73) Titulaire: ALSTOM Transport Technologies, 93400 Saint-Ouen (FR)
(72) Inventeur: PAPAGEORGIOU, Achilles, 1480 TUBIZE (BE)
(74) Mandataire: Lavoix

(56) Documents cités:
- EP-A1- 2 752 672
- DE-A1-102012 006 269
- US-A1- 2013 154 672

## Description

La présente invention concerne une chaîne de mesure pour un circuit électronique de signalisation comportant :
- au moins une résistance de mesure propre à être intégrée dans le circuit de signalisation, et
- au moins une chaîne d'acquisition comportant des moyens de mesure de la tension reliés aux bornes de la résistance de mesure.

Un circuit électrique de signalisation est un circuit dont le rôle est de fournir une information, par exemple visuelle, sur l'état de fonctionnement d'une installation.

Par exemple, un tel circuit de signalisation comporte un voyant qui est allumé lorsque l'installation est dans un premier état et éteint lorsque l'installation est dans un second état.

Le circuit de signalisation peut fournir une information erronée en cas de défaillance de certains de ses composants, c'est pourquoi il est connu de prévoir une chaîne de mesure sur le circuit de signalisation pour vérifier son bon fonctionnement.

La chaîne de mesure comporte un capteur de courant permettant de vérifier la circulation d'un courant dans le circuit de signalisation.

Le capteur de courant est constitué par une résistance et un dispositif de mesure de tension relié aux bornes de la résistance. La chute de tension mesurée entre les bornes de la résistance est proportionnelle au courant à déterminer (loi d'Ohm).

Pour s'assurer du bon fonctionnement du capteur, il est nécessaire d'effectuer régulièrement des tests du capteur, et notamment de sa résistance.

Un test de fonctionnement est, par exemple, effectué grâce à des commutateurs qui imposent, aux bornes de la résistance, un signal de test au lieu du signal mesuré. Ces commutateurs connectent la résistance à un circuit fournissant un signal de test connu au lieu du circuit de signalisation. La chute de tension aux bornes de la résistance est mesurée. Si la valeur mesurée correspond à la valeur prédite pour le signal de test, la résistance est considérée comme fonctionnant correctement. Un tel test d'un capteur est connu et par exemple décrit par WO 2004/062170 A2.

US 2013/154672 A1 décrit également une chaîne de mesure du type précité.

DE 10 2012 006269 A1 concerne un dispositif de mesure de la tension électrique aux bornes d'une batterie 1 de véhicule.

EP 2 752 672 A1 décrit un système de mesure de la valeur d'une structure de résistance

Pendant le temps de test, le circuit de signalisation est inopérant, puisque si les commutateurs assurent la connexion de la résistance au circuit fournissant un signal de test, le circuit de signalisation est ouvert et donc arrêté. Ceci est gênant pour certains systèmes. C'est pourquoi généralement, les tests sont effectués seulement lors de l'initialisation du circuit de signalisation et non pendant son fonctionnement.

L'invention a pour but de permettre de tester le fonctionnement du capteur de courant, sans qu'une réinitialisation du circuit ne soit nécessaire.

A cet effet, l'invention a pour objet une chaîne de mesure selon la revendication 1.

La possibilité d'une connexion permanente de la résistance de mesure avec le circuit de signalisation permet d'opérer le circuit de signalisation indépendamment des tests effectués par la chaîne de mesure et la résistance de test ayant une résistance très supérieure à la résistance de mesure, l'essentiel du courant du circuit de signalisation passe par la résistance de mesure.

Suivant des modes particuliers de réalisation, la chaîne de mesure est selon l'une quelconque des revendications 2 à 9.

L'invention a également pour objet un circuit de signalisation selon la revendication 10.

L'invention sera mieux comprise à la lecture de la description qui va suivre, donnée uniquement à titre d'exemple, et faite en se référant aux dessins annexés, sur lesquels :
- la figure 1 est un schéma électrique d'un circuit électrique principal et d'un circuit de signalisation associé ;
- la figure 2 est un schéma électrique d'une chaîne de mesure selon l'invention, intégré au circuit de signalisation de la figure 1 ; et
- la figure 3 est un schéma électrique d'une chaîne d'activation d'un test.

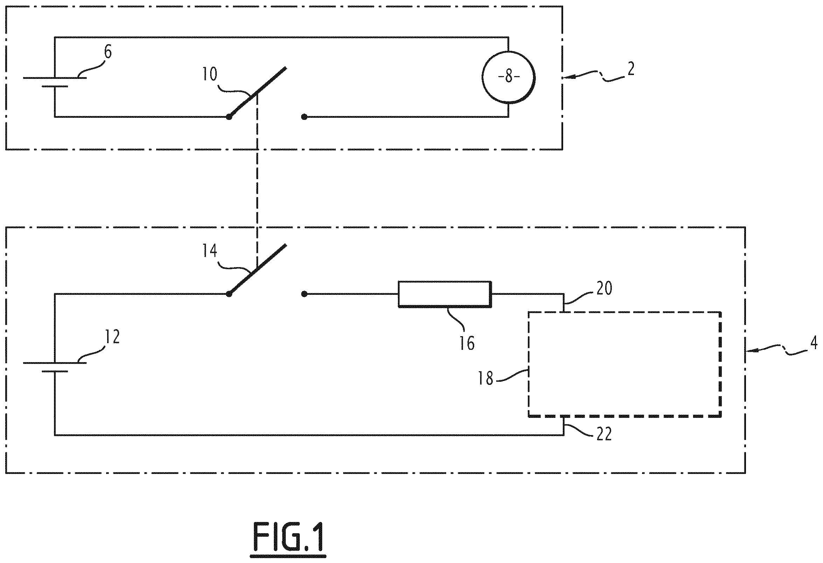

Sur la figure 1 sont représentés un circuit électrique principal 2 et un circuit de signalisation 4 associé. Le circuit de signalisation 4 est propre à donner une information sur l'état de fonctionnement du circuit électrique principal 2.

Le circuit électrique principal 2 est propre, par exemple, à exploiter un moteur pour une utilisation externe. Il comporte, reliés en série, une source d'énergie 6, un moteur 8 et un interrupteur 10. La source d'énergie 6 est apte à fournir, par exemple, une tension de 2 kV de courant alternatif pour alimenter le moteur 8.

Le circuit de signalisation 4 comporte, reliés en série, une source d'énergie 12, un interrupteur 14, une lampe 16 formant une charge et une chaîne de mesure 18 du courant circulant dans le circuit 4. La source d'énergie 12 est, par exemple, apte à fournir un courant de 24 volts de courant continu ou de 110 volts de courant alternatif.

L'interrupteur 14 est couplé mécaniquement à l'interrupteur 10 du circuit électrique principal de telle sorte que les deux interrupteurs 10, 14 sont toujours dans un même état, ouvert ou fermé. Ainsi, si le circuit électrique principal 2 est fermé/ouvert, le circuit de signalisation 4 est également fermé/ouvert et inversement. Avec cette structure, le circuit de signalisation 4 est donc apte à donner l'information sur l'état de l'interrupteur 10.

La chaîne de mesure 18 est reliée au circuit de signalisation 4 par une entrée 20 et une sortie 22.

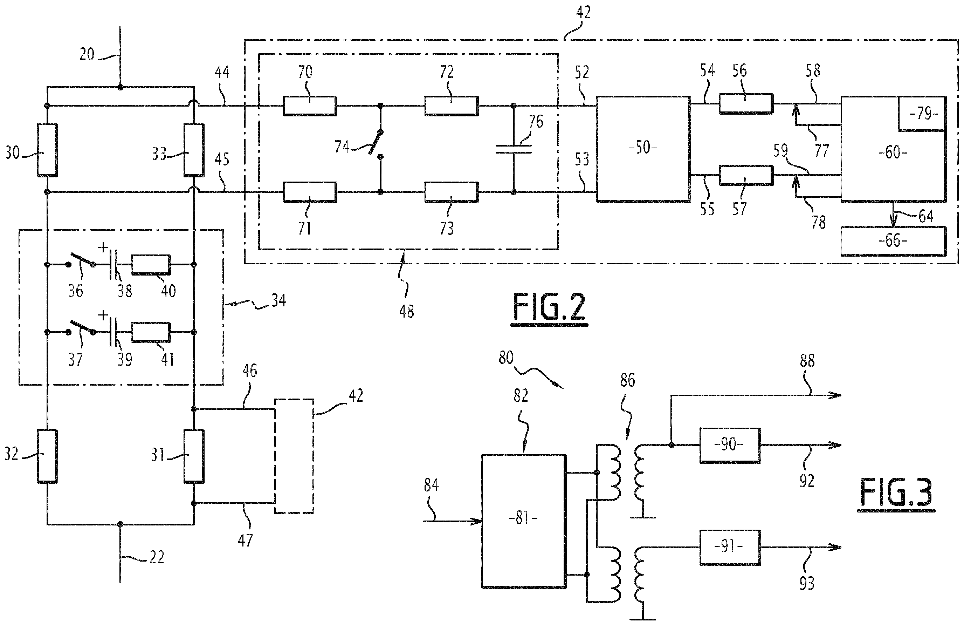

La chaîne de mesure 18 est représentée seule sur la figure 2. Elle comporte deux branches de mesure reliées en parallèle entre l'entrée 20 et la sortie 22. Chaque branche a respectivement, en série, une résistance de mesure 30, 31 et une résistance d'équilibrage 32, 33 respectivement.

Un excitateur 34 de test d'impulsion est relié entre les points milieux des deux branches parallèles, c'est-à-dire entre la résistance de mesure 30, 31 et la résistance d'équilibrage 32, 33 respectivement. Il est constitué par deux branches d'excitation reliées en parallèle entre les points milieux.

Chaque branche d'excitation comporte respectivement un commutateur commandable 36, 37 pour lancer le test d'impulsion, une source de tension 38, 39 propre à fournir une impulsion de courant et une résistance de test 40, 41 apte à limiter la valeur maximale de l'impulsion de courant. Les sources de tension 38 et 39, formées par exemple chacune par un condensateur, sont de préférence aptes à fournir une tension, inverse l'une de l'autre. Les commutateurs 36, 37 sont formés par exemple de transistors MOSFET.

Les valeurs des résistances de mesure et d'équilibrage 30 à 33 sont petites par rapport aux valeurs des résistances de test 40 et 41.

Par exemple, les résistances de mesure et d'équilibrage 30 à 33 ont même une valeur de résistance de 0,1 Ohm, la résistance de test 40 a une valeur de résistance de 33 Ohm et la résistance de test 41 a une valeur de résistance de 47 Ohm. De préférence, le rapport entre les valeurs de chaque résistance de test 40, 41 et les valeurs de chaque résistance de mesure 30, 31 et/ou d'équilibrage 32, 33 est supérieur à 10, avantageusement à 100 et de manière plus préférentielle supérieur à 300.

Le courant passant de l'entrée 20 à la sortie 22 est déterminé par deux chaînes d'acquisition 42 connectées respectivement aux bornes de la résistance de mesure 30 par des lignes 44 et 45 et aux bornes de la résistance de mesure 31 par des lignes 46 et 47. Les deux chaînes d'acquisition 42 ont des composants identiques et ont le même comportement comme décrit ci-dessous.

Chaque chaîne d'acquisition 42 est propre à mesurer la tension entre les bornes de la résistance de mesure 30, 31, laquelle est proportionnelle au courant passant par la résistance de mesure 30, 31.

Chaque chaîne d'acquisition 42 comporte, en entrée, un quadripôle de shunt commandable 48 relié en entrée aux bornes de la résistance 30, 31 par des lignes 44, 45 et 46, 47 respectivement. Les deux autres bornes du quadripôle de shunt formant une sortie sont reliées à un convertisseur 50 de la chaîne d'acquisition 42 par des lignes d'entrée 52, 53.

Le convertisseur 50 formant un moyen de mesure de la tension aux bornes de la résistance de mesure 30, 31 est propre à convertir un signal analogique en un signal numérique. Il comporte un encodeur sigma delta connu en soi suivi d'un décodeur. Le convertisseur 50 comprend deux lignes de sortie 54, 55 reliées chacune au travers d'une résistance 56, 57 limitant le courant aux entrées 58, 59 d'un calculateur 60.

Le calculateur 60 est apte à comparer les tensions mesurées entre les deux bornes de la résistance de mesure 30, 31 à des valeurs de référence dans les deux états des commutateurs 36, 37.

Dans un mode de réalisation préféré, le calculateur 60 est formé d'un FPGA.

Le calculateur 60 est propre à envoyer le résultat de la comparaison effectuée par au moins une ligne de sortie 64 à des moyens de qualification 66 formés par exemple d'un écran.

Dans un autre mode de réalisation, non représenté, les moyens de qualification 66 sont aptes à transmettre le signal à un ordinateur relié pour un traitement supplémentaire.

Le quadripôle 48 de shunt commandable comporte deux branches parallèles ayant chacune une résistance de test 70, 71 et une résistance 72, 73 en série. Une branche de liaison ayant le commutateur commandable 74 relie les points milieux des deux branches parallèles entre les résistances 70 et 72 et les résistances 71 et 73.

Une capacité 76 relie les lignes d'entrée 52, 53 auxquelles sont reliées les résistances 72, 73.

La valeur des résistances de test 70 et 71 est par exemple 22 Ohm. La valeur des résistances 72 et 73 est par exemple 215 Ohm. De préférence, le rapport entre les valeurs de la résistance de test 70, 71 et la résistance de mesure 30, 31 et/ou d'équilibrage 32, 33 est supérieur à 100.

Le commutateur 74 est, par exemple, un transistor à effet de champ (FET).

Le calculateur 60 comporte pour chaque ligne d'entrée 58, 59 respectivement une ligne 77, 78 de retour. Le calculateur est apte à émettre un signal de test dans chaque ligne 77, 78 de retour. Grâce à la liaison des lignes 77, 78 de retour aux lignes d'entrée 58, 59, les moyens de comparaison 60 sont aptes à effectuer un autotest du fonctionnement décrit ultérieurement.

Le calculateur 60 intègre une unité de commande 79 apte à envoyer des commandes dans la chaîne de mesure 18, et notamment à produire les signaux de test sur les lignes 77 et 78 et assurer le pilotage du commutateur 74.

L'unité de commande 79 est propre également, en fonction d'un séquencement qui sera décrit dans la suite, à commander l'état des commutateurs 36, 37 et à commander la charge des condensateurs 38, 39 à partir du circuit 80 de pilotage de l'excitateur 34 illustré sur la figure 3.

Le circuit de pilotage 80 comporte un hacheur 81 de puissance qui est propre à commander conjointement le commutateur 36, 37 et à assurer la charge du condensateur 38, 39. Un circuit de pilotage 80 tel que décrit en regard de la figure 3 est mis en œuvre pour chaque branche de l'excitateur, c'est-à-dire pour chaque interrupteur 36, respectivement 37 et condensateur 38, respectivement 39. Chaque hacheur 81 est alimenté par une ligne d'alimentation électrique 82 et commandé par une ligne 84 de commande reliée à l'unité de commande 79.

Le hacheur 81 est par exemple un pont de transistors commandé propre à transformer un courant continu d'alimentation reçu sur la ligne d'alimentation 82 en un courant haute-fréquence produit en sortie. La commande des transistors est assurée par l'unité de commande 79.

La sortie du hacheur 81 est reliée au primaire d'un transformateur 86 à double bobinage en série. Le transformateur 86 comporte deux bobinages secondaires indépendants, reliés chacun à une entrée d'un redresseur 90 et 91. La sortie des redresseurs 90 et 91 est reliée respectivement par des lignes de charge 92, 93 aux bornes d'un condensateur 38, 39. Cette liaison permet un chargement de la source de tension 38, 39 à l'aide d'un courant redressé.

En outre, une ligne de commande 88 est piquée sur la sortie de l'un des bobinages secondaires. Cette ligne est reliée au commutateur 36, 37 au travers d'un filtre passe-haut RC formant un retardateur et un redresseur.

Le filtre et le redresseur sont tels qu'à l'expiration de la constante de temps du retardateur, alors qu'un signal haute-fréquence est fourni sur la ligne de commande 88, un courant continu fourni par le redresseur assure la commande du commutateur 36, 37 pour le mettre dans un état passant. Cette constante de temps est choisie suffisamment grande pour permettre la charge du condensateur 38, 39 avant que le commutateur 36, 37 ne devienne passant.

L'unité de commande 79 est propre à piloter séparément les commutateurs 36, 37 en plus du commutateur 74.

Si l'interrupteur 14 est fermé et que la source d'énergie 12 fournit un courant, le courant passe par la lampe 16 et la chaîne de mesure 18. Dans la chaîne de mesure 18, le courant passe pour moitié par les résistances de mesure 30 et d'équilibrage 32 et pour moitié par les résistances de mesure 31 et d'équilibrage 33, les valeurs des résistances 30, 32 et 31, 33 étant égales.

En fonctionnement normal, les commutateurs 36, 37 et 74 sont ouverts et la chaîne d'acquisition 42 fournit sur l'afficheur 66 une valeur du courant circulant dans le circuit 4. Cette valeur est obtenue à partir de la tension mesurée aux bornes de la résistance 30, 31.

La chaîne de mesure 18 est propre de préférence à mettre en œuvre trois types de test sous la commande de l'unité de commande 79. Selon les modes de réalisation, la chaîne de mesure 18 comprend l'un ou plusieurs des tests suivants.

Le test d'impulsion a pour but de vérifier le fonctionnement de la résistance de mesure 30, 31, du convertisseur 50 et des moyens de comparaison 60. Ces composants sont dédiés à l'acquisition du courant et à la conversion dans une valeur numérique.

Au lancement du test d'impulsion, l'unité de commande 79 commande la charge d'une source de tension par exemple 38 grâce au circuit de pilotage 80 de la figure 3.

La charge est effectuée sous la commande de l'unité de commande 79 qui pilote le hacheur 80 pour alimenter le transformateur 86 qui alimente lui-même les redresseurs 90 et 91. Le courant continu ainsi produit charge les sources de tension 38 et 39.

A l'issue de la charge, le commutateur 36 est fermé alors que le circuit de signalisation 4 est toujours connecté et en fonctionnement.

La fermeture du commutateur 36 est commandée par le signal de haute fréquence transmis sur la ligne 88 et produit par le hacheur 81 sous la commande de l'unité de commande 79.

Cette implémentation apporte l'avantage d'une réduction des composants isolants, car la commande pour rendre passant le commutateur 36, 37 est transmise par le même circuit électrique que celui assurant la charge de la source de tension 38, 39.

Lorsque le test d'impulsion est lancé, grâce à la fermeture du commutateur 36, une impulsion de courant circule par les résistances 30, 33 et 40 ainsi que par les résistances 31, 32 et 41. Les résistances 40 de test fixent le courant pendant la décharge de la source de tension 38 afin d'avoir un courant déterminé qui permettra l'évaluation du circuit.

Pendant la décharge de la source de tension 38, le courant total passant la résistance de mesure 30, 31 change. Le courant injecté par la source de tension 38 suit une courbe exponentielle évanescente. La tension aux bornes de la résistance 30, 31 est acquise par la chaîne d'acquisition 42.

Les moyens de comparaison 60 comparent une courbe de tension acquise de référence pour une résistance fonctionnant correctement en l'absence de courant circulant entre les entrée 20 et sortie 22 et la courbe de tension acquise lors du test, de laquelle est déduite la dernière valeur de tension mesurée aux bornes de la résistance de mesure 30, 31 et obtenue en sortie du convertisseur 50.

La courbe de tension de référence pour un fonctionnement correct est mémorisée dans les moyens de comparaison 60.

Si les deux courbes sont proches, les moyens de comparaison 60 considèrent la résistance de mesure 30 comme fonctionnant correctement et le résultat est affiché sur l'écran 66. Sinon, un message d'erreur est affiché sur l'écran 66.

Un test identique est simultanément effectué pour la résistance de mesure 31.

Dans une deuxième partie du test, le commutateur 36 est ouvert et le commutateur 37 est fermé. Une impulsion de courant est alors injectée de manière similaire dans la chaîne de mesure 18, mais avec un courant de direction inverse à la première partie du test. Les mêmes comparaisons sont effectuées par les moyens de comparaison 60 avec des courbes de tension acquises de référence propres à la source de tension 37. Cette deuxième partie du test d'impulsion est implémentée pour assurer que l'acquisition du courant marche dans les deux sens de circulation du courant.

Il est possible d'effectuer le test à tout moment, avec n'importe quel signal émis par la source d'énergie 12. Il est également possible d'effectuer le test d'impulsion si l'interrupteur 14 est en état ouvert et qu'aucun courant, issu de la source d'énergie 12, ne passe par le circuit de signalisation 4. En conséquence, il n'est pas nécessaire d'activer ou d'arrêter le circuit électrique principal 2 ou le circuit de signalisation 4 pour effectuer un test d'impulsion.

Le test de décalage a pour but de calibrer l'entrée de convertisseur 50 et d'assurer qu'il n'y a pas de données mémorisées s'il y a un courant statique dans la chaîne de mesure 18, parce que la source d'énergie 12 fournit un courant continu, par exemple.

Le test est lancé par la fermeture du commutateur 74 sous la commande de l'unité de commande 79 alors que le courant circule ou non dans le circuit 4.

S'il y a une différence de potentiel entre les lignes 52 et 53, un courant passe par les résistances 72 et 73 et en conséquence le potentiel entre les lignes 52 et 53 devient nul.

Les moyens de comparaison 60 mesurent, après une conversion des valeurs en numérique par le convertisseur 50, la différence de potentiel entre les lignes 52 et 53 et le comparent avec la valeur prédite, qui est normalement nulle.

Les résistances de test 70 et 71 de forte valeur par rapport aux résistances 30, 31 sont propres à garantir une circulation de l'essentiel du courant vers la résistance de mesure 30.

Si le potentiel entre les lignes 52 et 53 n'est pas nul pendant le test de décalage, le commutateur 74, le convertisseur 50 ou les moyens de comparaison 60 ne fonctionnent pas correctement. Cette information est affichée sur l'écran 66.

Ce test est également effectué indépendamment de l'état du circuit de signalisation 4. De préférence, le test de décalage est effectué après l'exécution du test d'impulsion.

Le test de retour a pour but de tester le fonctionnement des moyens de comparaison 60, par exemple du FPGA.

Un signal de test, fourni par un convertisseur ΣΔ, non représenté, à l'intérieur du FPGA 60, est injecté par la ligne 77, 78 de retour dans les lignes 58, 59, à l'entrée des moyens de comparaison 60.

Le signal de test de niveau élevé outrepasse le signal mesuré, qui vient du convertisseur 50. Les moyens de comparaison détectent le signal de test injecté et indique un fonctionnement normal sur l'écran 66. Sinon rien n'est affiché sur l'écran 66.

Ce test est également indépendant de l'état du circuit de signalisation 4. Si le signal détecté par le FPGA ne correspond au signal prédit, le FPGA est déficient.

En variante, l'ensemble des interrupteurs 10 et 14 est un relais. Dans cette variante, le circuit de signalisation 4 est un circuit de commande, qui est apte à commander le relais. Le relais est propre à interrompre ou fermer le circuit électrique principal 2, qui est un circuit de charge dans cette variante.

En variante encore, le déclencheur 34 de test d'impulsion ne comporte qu'une seule branche avec un commutateur 36, une source de tension 38 et une résistance 40. Dans cette variante, le déclencheur 34 de test d'impulsion n'est donc qu'apte à fournir une impulsion de courant dans une direction.

Dans un mode de réalisation, des informations supplémentaires sont transférées par la ligne de sortie 64 aux moyens de qualification 66, telles que le type d'alimentation de la source d'énergie 12 ou des valeurs correspondantes d'une tension ou d'un courant.

Des tests de circuit interne, qui seront expliqués ci-après, sont lancés de manière indépendante de l'état de l'interrupteur 14. Ils sont, par exemple, lancés par le FPGA en réponse à la satisfaction d'une certaine condition ou manuellement par un utilisateur.

## Revendications

1. Chaîne de mesure (18) pour un circuit électronique de signalisation (4) comportant :
- au moins une résistance de mesure (30, 31) étant propre à être intégrée dans le circuit de signalisation (4),
- au moins une chaîne d'acquisition (42) comportant des moyens (50) de mesure de la tension reliés aux bornes de la résistance de mesure (30, 31), et
- au moins une résistance de test (40, 41, 70, 71) et au moins un commutateur commandable (36, 37, 74) associés reliés à la résistance de mesure (30, 31) ;
le rapport de la valeur de la résistance de test (40, 41, 70, 71) sur la valeur de la résistance de mesure (30, 31) étant supérieur à 10 ; et
la chaîne d'acquisition (42) comportant des moyens (60) de comparaison des tensions mesurées aux bornes de la résistance de mesure (30, 31) dans les deux états du commutateur (36, 37, 74) et des moyens de qualification (66) de la chaîne de mesure (18) en fonction du résultat de la comparaison,
**caractérisée en ce que** la chaîne de mesure (18) comporte en outre :
- deux branches parallèles ayant chacune une résistance de mesure (30, 31) ; et
- au moins un excitateur de test d'impulsion (34) connecté entre les deux bornes des deux résistances de mesure (30, 31) et comprenant ladite au moins une résistance de test (40, 41, 70, 71) et ledit au moins un commutateur commandable (36, 37, 74).

2. Chaîne de mesure (18) selon la revendication 1, **caractérisée en ce que** chaque branche parallèle comporte, montée en série avec la résistance de mesure (30, 31), une résistance d'équilibrage (32, 33), disposée de sorte que l'excitateur de test d'impulsion (34) est connecté entre les points milieux des résistances de mesure (30, 31) et d'équilibrage (32, 33) d'une même branche.

3. Chaîne de mesure (18) selon la revendication 1 ou 2, **caractérisée en ce que** l'excitateur de test d'impulsion (34) comporte une source de tension (38, 39) montée en série avec le commutateur (36, 37) commandable.

4. Chaîne de mesure (18) selon la revendication 3, **caractérisée en ce que** l'excitateur de test d'impulsion (34) comporte deux branches de liaison en parallèle, chaque branche de liaison comprenant une source de tension (38, 39) montée en série avec un commutateur commandable (36, 37), les deux sources de tension (38, 39) étant aptes à fournir des impulsions de courant de sens opposés l'une à l'autre.

5. Chaîne de mesure (18) selon la revendication 3 ou 4, **caractérisée en ce que** la source de tension (38, 39) comporte un accumulateur (38, 39) d'énergie électrique et des moyens (80) assurant conjointement la charge de l'accumulateur (38, 39) et la commande retardée du commutateur commandable (36, 37) depuis un même signal.

6. Chaîne de mesure (18) selon l'une quelconque des revendications précédentes, **caractérisée en ce qu'**elle comporte deux résistances de mesure (30, 31) et deux chaînes d'acquisition (42) connectées chacune aux bornes d'une résistance de mesure (30, 31).

7. Chaîne de mesure (18) selon l'une quelconque des revendications précédentes, **caractérisée en ce qu'**elle comporte au moins une résistance de test (70, 71) interposée entre une borne de la résistance de mesure (30, 31) et les moyens de mesure de la tension (50) et le commutateur (74) est propre à la fois à assurer la mise en parallèle de la résistance de test (70, 71) avec la résistance de mesure (30, 31), et à court-circuiter les lignes d'entrée (52, 53) des moyens de mesure (50) de la tension aux bornes de la résistance de mesure (30, 31).

8. Chaîne de mesure (18) selon la revendication 7, **caractérisée en ce qu'**elle comporte deux résistances (70, 71) de test, chacune interposée entre des bornes différentes de la résistance de mesure (30, 31) et les moyens complémentaires de mesure de la tension (50).

9. Chaîne de mesure (18) selon une quelconque des revendications précédentes, **caractérisée en ce qu'**elle comporte des moyens (77, 78) d'injection, dans la chaîne d'acquisition (42), d'un signal de test supplémentaire en entrée des moyens de comparaison (60) et les moyens de comparaison (60) comportant des moyens de détection de ce signal de test supplémentaire.

10. Circuit de signalisation (4) comportant et reliés en série
- une source d'énergie (12) ;
- un interrupteur (14) couplé à un interrupteur (10) d'un circuit électrique principal (2) ;
- une charge (16) ; et
- une chaîne de mesure (18) selon l'une quelconque des revendications précédentes.

## Patentansprüche

1. Messkette (18) für einen elektronischen Signalschaltkreis (4), aufweisend:
- mindestens einen Messwiderstand (30, 31), der geeignet ist, in den Signalschaltkreis (4) integriert zu werden,
- mindestens eine Erfassungskette (42), die Mittel (50) zur Messung der Spannung aufweist, die an die Anschlüsse des Messwiderstands (30, 31) angeschlossenen sind, und
- mindestens einen Prüfwiderstand (40, 41, 70, 71) und mindestens einen steuerbaren Schalter (36, 37, 74), die dem Messwiderstand (30, 31) zugeordnet und mit diesem verbunden sind;
wobei das Verhältnis des Wertes des Prüfwiderstandes (40, 41, 70, 71) zum Wert des Messwiderstandes (30, 31) größer als 10 ist; und
die Erfassungskette (42) Mittel (60) zum Vergleichen der an den Anschlüssen des Messwiderstands (30, 31) in den beiden Zuständen des Schalters (36, 37, 74) gemessenen Spannungen und Mittel (66) zur Qualifikation der Messkette (18) entsprechend dem Ergebnis des Vergleichs aufweist,
**dadurch gekennzeichnet, dass** die Messkette (18) weiterhin aufweist:
- zwei parallele Zweige mit jeweils einem Messwiderstand (30, 31); und
- mindestens eine Prüfimpuls-Erregungsvorrichtung (34), die zwischen die beiden Anschlüsse der beiden Messwiderstände (30, 31) geschaltet ist und den mindestens einen Prüfwiderstand (40, 41, 70, 71) und den mindestens einen steuerbaren Schalter (36, 37, 74) umfasst.

2. Messkette (18) nach Anspruch 1, **dadurch gekennzeichnet, dass** jeder Parallelzweig einen mit dem Messwiderstand (30, 31) in Reihe geschalteten Abgleichwiderstand (32, 33) aufweist, der derart angeordnet ist, dass die Prüfimpuls-Erregungsvorrichtung (34) zwischen den Mittelpunkten von Mess- (30, 31) und Abgleichwiderstand (32, 33) desselben Zweiges angeschlossen ist.

3. Messkette (18) nach Anspruch 1 oder 2, **dadurch gekennzeichnet, dass** die Prüfimpuls-Erregungsvorrichtung (34) eine mit dem steuerbaren Schalter (36, 37) in Reihe geschaltete Spannungsquelle (38, 39) aufweist.

4. Messkette (18) nach Anspruch 3, **dadurch gekennzeichnet, dass** die Prüfimpuls-Erregungsvorrichtung (34) zwei parallel geschaltete Verbindungszweige aufweist, wobei jeder Verbindungszweig eine Spannungsquelle (38, 39) umfasst, die mit einem steuerbaren Schalter (36, 37) in Reihe geschaltet ist, wobei die beiden Spannungsquellen (38, 39) geeignet sind, Stromimpulse in entgegengesetzter Richtung zueinander zu liefern.

5. Messkette (18) nach Anspruch 3 oder 4, **dadurch gekennzeichnet, dass** die Spannungsquelle (38, 39) einen elektrischen Energiespeicher (38, 39) und Mittel (80) aufweist, die gemeinsam die Aufladung des Speichers (38, 39) und die verzögerte Ansteuerung des steuerbaren Schalters (36, 37) aus einem einzigen Signal sicherstellen.

6. Messkette (18) nach einem der vorhergehenden Ansprüche, **dadurch gekennzeichnet, dass** sie zwei Messwiderstände (30, 31) und zwei Erfassungsketten (42) aufweist, die jeweils mit den Anschlüssen eines Messwiderstandes (30, 31) verbunden sind.

7. Messkette (18) nach einem der vorhergehenden Ansprüche, **dadurch gekennzeichnet, dass** sie mindestens einen Prüfwiderstand (70, 71) aufweist, der zwischen einem Anschluss des Messwiderstandes (30, 31) und den Mitteln (50) zur Messung der Spannung angeordnet ist, und dass der Schalter (74) geeignet ist, sowohl die Parallelschaltung des Prüfwiderstandes (70, 71) mit dem Messwiderstand (30, 31) sicherzustellen als auch die Eingangsleitungen (52, 53) der Mittel (50) zur Messung der Spannung an den Anschlüssen des Messwiderstandes (30, 31) kurzzuschließen.

8. Messkette (18) nach Anspruch 7, **dadurch gekennzeichnet, dass** sie zwei Prüfwiderstände (70, 71) aufweist, die jeweils zwischen verschiedenen Anschlüssen des Messwiderstandes (30, 31) und den komplementären Mitteln zur Messung (50) der Spannung angeordnet sind.

9. Messkette (18) nach einem der vorhergehenden Ansprüche, **dadurch gekennzeichnet, dass** sie Mittel (77, 78) zum Einspeisen eines zusätzlichen Prüfsignals am Eingang der Vergleichsmittel (60) in die Erfassungskette (42) aufweist und die Vergleichsmittel (60) Mittel zum Erfassen dieses zusätzlichen Prüfsignals aufweisen.

10. Signalisierungsschaltkreis (4), der folgende in Reihe geschaltete Elemente aufweist
- eine Energiequelle (12);
- einen Schalter (14), der mit einem Schalter (10) eines elektrischen Hauptstromkreises (2) gekoppelt ist;
- eine Last (16); und
- eine Messkette (18) nach einem der vorhergehenden Ansprüche.

## Claims

1. A measuring chain (18) for a signaling electronic circuit (4), including:
- at least one measuring resistance (30, 31) able to be integrated into the signaling circuit (4),
- at least one acquisition chain (42) including means (50) for measuring the voltage connected across the terminals of the measuring resistance (30, 31), and
- at least one test resistance (40, 41, 70, 71) and at least one controllable switch (36, 37, 74), associated, connected to the measuring resistance (30, 31);
the ratio of the value of the test resistance (40, 41, 70, 71) to the value of the measuring resistance (30, 31) being greater than 10; and
the acquisition chain (42) including means (60) for comparing voltages measured across the terminals of the measuring resistance (30, 31) in the two states of the switch (36, 37, 74) and means (66) for qualifying the measuring chain (18) based on the result of the comparison,
**characterized in that** the measuring chain (18) further includes:
- two parallel branches each having a measuring resistance (30, 31); and
- at least one impulse test exciter (34) connected between the two terminals of the two measuring resistances (30, 31) and comprising said at least one test resistance (40, 41, 70, 71) and said at least one controllable switch (36, 37, 74).

2. The measuring chain (18) according to claim 1, **characterized in that** each parallel branch includes, mounted in series with the measuring resistance (30, 31), a balance resistance (32, 33), arranged such that the impulse test exciter (34) is connected between the midpoints of the measuring (30, 31) and balance (32, 33) resistances of a same branch.

3. The measuring chain (18) according to claim 1 or 2, **characterized in that** the impulse test exciter (34) includes a voltage source (38, 39) mounted in series with the controllable switch (36, 37).

4. The measuring chain (18) according to claim 3, **characterized in that** the impulse test exciter (34) includes two connecting branches in parallel, each connecting branch comprising a voltage source (38, 39) mounted in series with a controllable switch (36, 37), the two voltage sources (38, 39) being able to provide current impulses with opposite directions relative to one another.

5. The measuring chain (18) according to claim 3 or 4, **characterized in that** the voltage source (38, 39) includes an electrical energy accumulator (38, 39) and means (80) jointly ensuring charging of the accumulator (38, 39) and the delayed control of the controllable switch (36, 37) from a same signal.

6. The measuring chain (18) according to any one of the preceding claims, **characterized in that** it includes two measuring resistances (30, 31) and two acquisition chains (42) each connected to the terminals of a measuring resistance (30, 31).

7. The measuring chain (18) according to any one of the preceding claims, **characterized in that** it includes at least one test resistance (70, 71) inserted between a terminal of the measuring resistance (30, 31) and the measuring means (50) for the voltage, and the switch (74) is able both to ensure the placement in parallel of the test resistance (70, 71) with the measuring resistance (30, 31), and to short-circuit the input lines (52, 53) of the means (50) measuring the voltage across the terminals of the measuring resistance (30, 31).

8. The measuring chain (18) according to claim 7, **characterized in that** it includes two test resistances (70, 71), each inserted between different terminals of the measuring resistance (30, 31) and the additional voltage measuring means (50).

9. The measuring chain (18) according to any one of the preceding claims, **characterized in that** it includes means (77, 78) for injecting, in the acquisition chain (42), an additional test signal at input of the comparison means (60) and the comparison means (60) including means for detecting this additional test signal.

10. A signaling circuit (4) including, and connected in series:
- a power source (12);
- an interrupter (14) coupled to an interrupter (10) of a main electrical circuit (2);
- a load (16); and
- a measuring chain (18) according to any one of the preceding claims.
